# EUROPEAN PATENT APPLICATION

(11) **EP 2 811 649 A2**
(43) Date of publication of application: **10.12.2014**
(21) Application number: 14169586.6
(22) Date of filing: 23.05.2014
(51) Int. Cl.: H03K 17/693

(54) **Switch, radio frequency chip, and board**

(30) Priority: 05.06.2013 CN 201310220945
(71) Applicant: Huawei Technologies Co., Ltd., Shenzhen, Guangdong 518129 (CN)
(72) Inventor: Wang, Hongyu, 518129, P.R. Shenzhen Guangdong (CN); Peng, Rong, 518129, P.R. Shenzhen, Guangdong (CN); Liu, Quan, 518129, P.R. Shenzhen, Guangdong (CN)
(74) Representative: Lord, Michael

(57) **Abstract**

The present invention provides a switch, a radio frequency chip, and a board. A bias voltage is set by using a bias voltage setting circuit (11), which increases a direct-current level of an input signal (Pi), avoids as far as possible that a switch unit (12) which should be turned off is turned on in a case where a large signal is input into a switch circuit, optimizes the performance of the switch unit (12) in an off state in a switch such as a CMOS SPNT switch in a case where a large signal is input, and effectively improves the linearity and isolation of the switch such as the CMOS SPNT switch.

## Description

### TECHNICAL FIELD

The present invention relates to switch circuit technologies, and in particular, to a switch, a radio frequency chip, and a board.

### BACKGROUND

A single pole N throw (Single Pole N Throw, SPNT) switch is often used on a radio frequency board, a base station, and a microwave board. For example, a radio frequency board of a terminal needs to use a high-performance SPNT switch supporting multiple standards: 2G/3G/4G, and a base station and a microwave board also often uses an SPNT switch when a radio frequency chip needs to support a multi-mode or multi-bandwidth filter.

The terminal has high requirements on isolation and linearity of the SPNT switch, and the base station and the microwave board have extremely high requirements on the linearity of the SPNT switch; therefore, on these occasions, a separate commercial device is mostly used to implement the SPNT switch by means of a group III-V semiconductor process such as a GaAs or InP process. The separate commercial device refers to that a single device is implemented by using a single chip, or in other words, each device is a chip and different devices are implemented by using different chips.

However, under the impetus of a demand for application of the radio frequency board, it becomes especially urgent to reduce the area and cost of the radio frequency board and achieve high integration, intellectualization and miniaturization of the board. The SPNT switch implemented by using the separate commercial device occupies a large area of the board and cannot meet the demand.

To solve the foregoing problem, currently, some attempts have also been made in the industry to implement the SPNT switch based on a complementary metal oxide semiconductor (Complementary Metal Oxide Semiconductor, CMOS) process, that is, a CMOS SPNT switch.

The SPNT switch implemented by using the CMOS process in the prior art is formed by multiple switch circuits, a switch of each switch circuit being implemented by using turn-on or turn-off of a field-effect transistor, and has at least the following defects: the isolation between ports is poor, and it is very difficult to improve the isolation; and the linearity is low, and branches and input/output affect each other, thereby limiting the improvement of the linearity.

### SUMMARY

In view of this, embodiments of the present invention provide a switch, a radio frequency chip, and a board, so as to improve the linearity and isolation of a CMOS SPNT switch.

According to a first aspect, an embodiment of the present invention provides a switch, including:
a first bias voltage setting circuit, including a first capacitor and a first resistor, where a first end of the first capacitor is a signal input end, a second end of the first capacitor is connected to a first end of the first resistor, and a second end of the first resistor is connected to a first bias voltage; and
at least one switch unit, where each switch unit of the at least one switch unit includes a first transistor, a second transistor, a third transistor, a second resistor, and a third resistor; a drain of the first transistor is connected to the second end of the first capacitor, a source of the first transistor is connected to a drain of the second transistor, and a gate of the first transistor is connected to a first end of the second resistor; a gate of the second transistor is connected to a first end of the third resistor, and a source of the second transistor is connected to a signal output end; a second end of the second resistor is connected to a second end of the third resistor and is connected to a first control signal; and a source of the third transistor is grounded, a drain of the third transistor is connected to a node on a connection line between the source of the first transistor and the drain of the second transistor, and a gate of the third transistor is connected to a second control signal, where the first control signal and the second control signal are used to control turn-on or turn-off of the first transistor, the second transistor, and the third transistor, and a logic level of the first control signal is opposite to a logic level of the second control signal.

With reference to the first aspect, in a first possible implementation manner of the first aspect, the switch further includes:
at least one second bias voltage setting circuit, where the number of the at least one second bias voltage setting circuit is the same as the number of the at least one switch unit, and the at least one second bias voltage setting circuit is connected to the at least one switch unit in a one-to-one correspondence manner;
each second bias voltage setting circuit of the at least one second bias voltage setting circuit includes a second capacitor and a fourth resistor, where a first end of the second capacitor, the source of the second transistor, and a first end of the fourth resistor are connected at one point, a second end of the fourth resistor is connected to a second bias voltage, and a second end of the second capacitor is a signal output end; and
the second bias voltage is equal to the first bias voltage.

With reference to the first aspect or the first possible implementation manner of the first aspect, in a second possible implementation manner of the first aspect, the first transistor, the second transistor, and the third transistor are triple-well transistors.

With reference to the second possible implementation manner of the first aspect, in a third possible implementation manner of the first aspect, in each triple-well transistor, an N well is connected to a power supply by using a resistor, a P well is connected to a source of the triple-well transistor by using another resistor, and the power supply is configured to supply power for the triple-well transistor.

With reference to the first aspect or any possible implementation manner of the first to third possible implementation manners of the first aspect, in a fourth possible implementation manner of the first aspect, high levels of the first control signal and the second control signal are greater than or equal to 2.5V.

According to a second aspect, an embodiment of the present invention provides a radio frequency chip, including a control circuit and any one of the foregoing switches, where the control circuit is configured to provide a first control signal and a second control signal for the switch, and the control circuit controls turn-on or turn-off of at least one switch unit in the switch by using the first control signal and the second control signal.

With reference to the second aspect, in a first possible implementation manner of the second aspect, when the at least one switch unit in the switch is multiple switch units, the control circuit is further configured to control turn-on of any switch unit of the multiple switch units and control turn-off of other switch unit than the any switch unit of the multiple switch units.

With reference to the second aspect or the first possible implementation manner of the second aspect, in a second possible implementation manner of the second aspect, the chip further includes a bias voltage circuit,
where the bias voltage circuit is connected to a second end of a first resistor in a first bias voltage setting circuit of the switch, and is configured to provide a first bias voltage for the switch.

With reference to the second possible implementation manner of the second aspect, in a third possible implementation manner of the second aspect, when the switch includes a second bias voltage setting circuit, the bias voltage circuit is further connected to a second end of a fourth resistor in the second bias voltage setting circuit of the switch, and is configured to provide a second bias voltage for the switch, where the second bias voltage is equal to the first bias voltage.

With reference to the second possible implementation manner of the second aspect, in a fourth possible implementation manner of the second aspect, when the switch includes a second bias voltage setting circuit, the bias voltage circuit includes a first bias voltage circuit and a second bias voltage circuit, where
the first bias voltage circuit is connected to the second end of the first resistor in the first bias voltage setting circuit, and is configured to provide the first bias voltage for the switch; and
the second bias voltage circuit is connected to a second end of a fourth resistor in the second bias voltage setting circuit, and is configured to provide the second bias voltage for the switch.

With reference to the third or fourth possible implementation manner of the second aspect, in a fifth possible implementation manner of the second aspect, both the first bias voltage and the second bias voltage are greater than 1.5 V and less than 1.9 V.

According to a third aspect, an embodiment of the present invention provides a board, including a bias voltage circuit and any one of the foregoing radio frequency chips, where the bias voltage circuit is configured to provide a first bias voltage for a switch in the radio frequency chip.

With reference to the third aspect, in a first possible implementation manner of the third aspect, when the switch includes a second bias voltage setting circuit, the bias voltage circuit is further configured to provide a second bias voltage for the switch, where the first bias voltage is equal to the second bias voltage.

In the switch, the radio frequency chip, and the board provided in the foregoing embodiments, a bias voltage is set by using a bias voltage setting circuit, which increases a direct-current level of an input signal, avoids as far as possible that a switch unit which should be turned off is turned on in a case where a large signal is input into a switch circuit, optimizes performance of the switch unit in an off state in a switch such as a CMOS SPNT switch in a case where a large signal is input, and effectively improves the linearity and isolation of the switch such as the CMOS SPNT switch.

### BRIEF DESCRIPTION OF DRAWINGS

To describe the technical solutions in the embodiments of the present invention more clearly, the following briefly introduces accompanying drawings required for describing the embodiments. Apparently, the accompanying drawings in the following description show merely some embodiments of the present invention, and persons of ordinary skill in the art may still derive other drawings according to these accompanying drawings without creative efforts.
FIG. 1 is a schematic structural diagram of a switch according to an embodiment of the present invention;
FIG. 2 is a circuit diagram of a switch according to another embodiment of the present invention;
FIG. 3 is a diagram of a bias voltage circuit in a switch according to another embodiment of the present invention;
FIG. 4 is a diagram of a bias voltage circuit in a switch according to another embodiment of the present invention;
FIG. 5 is a functional principle diagram of a switch circuit in a switch according to another embodiment of the present invention;
FIG. 6a is a schematic diagram of a transistor in a switch according to another embodiment of the present invention;
FIG. 6b is a schematic diagram of a triple-well transistor in a switch according to another embodiment of the present invention;
FIG. 6c is a series circuit diagram of a triple-well transistor in a switch according to another embodiment of the present invention;
FIG. 7 is a diagram of a relationship between an input voltage signal and a voltage on a gate of a transistor with a turned-off CMOS SPNT switch in a case where a bias voltage setting circuit is not used;
FIG. 8 is a diagram of a relationship which is between an input voltage signal and a voltage on a gate of a transistor with a turned-off switch and is obtained in circuit emulation of the switch shown in FIG. 2;
FIG. 9 is a curve diagram of an input compression point 1dB (Input Compression Point 1dB, ICP1dB) in circuit emulation of the switch shown in FIG. 2;
FIG. 10 is a schematic structural diagram of a radio frequency chip according to another embodiment of the present invention; and
FIG. 11 is a schematic structural diagram of a board according to another embodiment of the present invention.

### DESCRIPTION OF EMBODIMENTS

To make the objectives, technical solutions, and advantages of the present invention clearer, the following further describes the present invention in detail with reference to the accompanying drawings. Apparently, the embodiments to be described are merely a part rather than all of the embodiments of the present invention. All other embodiments obtained by persons of ordinary skill in the art based on the embodiments of the present invention without creative efforts shall fall within the protection scope of the present invention.

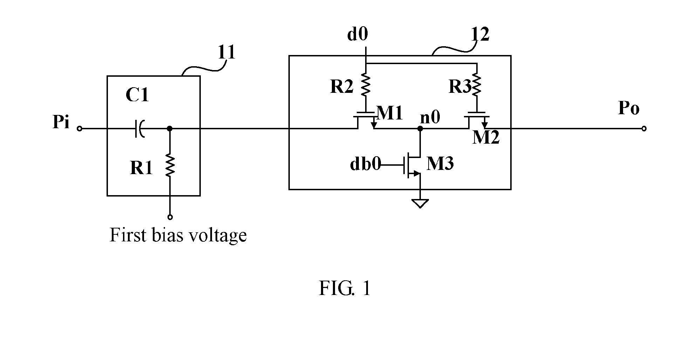

FIG. 1 is a schematic structural diagram of a switch according to an embodiment of the present invention. In this embodiment, the switch includes a first bias voltage setting circuit 11 and a switch unit 12.

The first bias voltage setting circuit 11 includes a first capacitor C1 and a first resistor R1, where a first end of the first capacitor C1 is a signal input end and is connected to an input signal Pi, a second end of the first capacitor C1 is connected to a first end of the first resistor R1, and a second end of the first resistor R1 is connected to a first bias voltage.

The switch unit 12 includes a first transistor M1, a second transistor M2, a third transistor M3, a second resistor R2, and a third resistor R3, where a drain of the first transistor M1 is connected to the second end of the first capacitor C1, a source of the first transistor M1 is connected to a drain of the second transistor M2, and a gate of the first transistor M1 is connected to a first end of the second resistor R2; a gate of the second transistor M2 is connected to a first end of the third resistor R3, a source of the second transistor M2 is connected to a signal output end, and a signal Po is output; a second end of the second resistor R2 is connected to a second end of the third resistor R3 and is connected to a first control signal d0; and a source of the third transistor M3 is grounded, a drain of the third transistor M3 is connected to a node n0 on a connection line between the source of the first transistor M1 and the drain of the second transistor M2, and a gate of the third transistor M3 is connected to a second control signal db0.

That is, the switch unit 12 includes two serially connected transistors and one transistor connected to a connecting point of the serially connected transistors, where a first signal connecting end of the one transistor is connected to the connecting point of the serially connected transistors, and a second signal connecting end thereof is grounded, so as to form a T-shaped switch structure. When the switch unit is turned off, the two serially connected transistors are connected to a low level, and the one transistor connected in parallel to the ground is connected to a low level. The turn-on or turn-off manner of the transistor with a T-shaped configuration can effectively improve the port isolation of each transistor as a switch.

The first control signal d0 and the second control signal db0 are used to control turn-on or turn-off of the first transistor M1, the second transistor M2, and the third transistor M3, and a logic level of the first control signal d0 is opposite to a logic level of the second control signal db0.

Specifically, when d0 is a high level and db0 is a low level, the first transistor M1 and the second transistor M2 are connected in series and are both turned on to play a part in transmitting a signal, and the serially connected first transistor M1 and second transistor M2 share the voltage drop on a path, which helps improve the linearity. In this case, the third transistor M3 is turned off, the node n0 presents a high impedance state relative to the ground, and the switch unit 12 is turned on.

When d0 is a low level and db0 is a high level, the first transistor M1 and the second transistor M2 are turned off, and the third transistor M3 is turned on. The first transistor M1 blocks a signal, and after an unblocked residual signal passes through the node n0, the unblocked residual signal is directly connected to the ground by the third transistor M3, and the switch unit 12 is turned off. The turn-off of the second transistor M2 further blocks the passage of a signal, thereby improving the isolation of the switch. The second resistor R2 and the third resistor R3 are configured to block the coupling of parasitic capacitances, so as to further improve the isolation and linearity.

Definitely, one switch unit may also include two or even more T-shaped switch structures, so as to further improve the isolation of the CMOS SPNT switch.

In addition, by increasing merely the number of serially connected transistors or increasing merely the number of transistors connected in parallel to the ground, the isolation of the CMOS SPNT switch may be further improved.

When the switch unit 12 is turned off, if the input voltage signal Pi is very large, due to the existence of the first bias voltage, a voltage of the drain of the first transistor M1 is not much lower than a voltage of the gate, which ensures that a voltage difference between the gate voltage and the drain voltage of the first transistor M1 is within a turn-off threshold, and further ensures that the second transistor M2 is in an off state, so that a turned-off MOS transistor is always in an off state under the control of the first control signal d0; in addition, because the voltage of the gate is lower than the voltage of the drain and the voltage of the source, a more thorough off state is achieved, thereby improving the linearity of the switch. In addition, the input voltage signal is attenuated to a greater extent when the input voltage signal passes through the MOS transistor, and therefore the signal reaching the node n0 is smaller; and then, the signal of the node n0 passes through the turned-on third transistor M3 and is connected to the ground, and the signal is further attenuated, thereby increasing the isolation.

There may be multiple switch units.

When there are multiple switch units, each switch unit has two control signals with opposite logic levels to control turn-on and turn-off of the switch units. In this case, the switch provided in the embodiment of the present invention may be a single-input single-output switch or a single-input multi-output switch. For example, if there are five switch units, by means of the control of a control signal, one of the switch units may be turned on to output one signal, and the rest switch units may be turned off to output no signals; or by means of the control of a control signal, two or even more switch units may be turned on to output signals, and the rest switch units may be turned off to output no signals.

Further, the switch provided in the embodiment of the present invention may further include at least one second bias voltage setting circuit, where the number of the at least one second bias voltage setting circuit is the same as the number of the at least one switch unit, and the at least one second bias voltage setting circuit is connected to the at least one switch unit in a one-to-one correspondence manner. For example, when there are two switch units, each switch unit is connected to one second bias voltage setting circuit, and therefore, there are two second bias voltage setting circuits; and when there are three switch units, each switch unit is connected to one second bias voltage setting circuit, and therefore, there are three second bias voltage setting circuits.

The second bias voltage setting circuit may include a second capacitor and a fourth resistor, a first end of the second capacitor, the source of the second transistor, and a first end of the fourth resistor are connected at one point, a second end of the fourth resistor is connected to a second bias voltage, and a second end of the second capacitor is a signal output end, and outputs a signal Po.

If the input signal Pi fluctuates greatly when the second bias voltage setting circuit is connected to the switch unit 12 and the first control signal d0 and the second control signal db0 control the switch unit to be turned on, since the second bias voltage and the first bias voltage jointly increase a logic high level of the input signal Pi, a voltage difference between a gate voltage and a drain voltage of the first transistor and a voltage difference between a gate voltage and a drain voltage of the second transistor are within a turn-on threshold, and a voltage difference between a gate voltage and a drain voltage of the third transistor is within a turn-off threshold, thereby avoiding a problem that, due to the great fluctuation of the input signal Pi, the first transistor, the second transistor, and the third transistor become off under the control of the control signal used to control the switch unit to be turned on, ensuring that the switch unit can be kept in an on state under the control of the control signal used to control the switch unit to be turned on, and further improving the linearity of the switch.

The second bias voltage is equal to the first bias voltage. Persons skilled in the art should know that the equality mentioned in the present invention is not the absolute equality in values; and a slight difference may exist between the first bias voltage and the second bias voltage in values, as long as it can be ensured that when the first bias voltage and the second bias voltage increase the logic high level of the input signal voltage of the switch unit, a state of the switch unit is not changed in a case where the control signal is not changed.

Further, the high levels of the first control signal and the second control signal may be greater than or equal to 2.5 V, so as to ensure the reliability of the transistors. For example, for CMOS processes using 1.8 V and 3 V, the logic high level of the first control signal and the logic high level of the second control signal may be increased to 3 V and 5 V respectively.

Further, both the first bias voltage and the second bias voltage may be greater than 1.5 V and less than 1.9 V

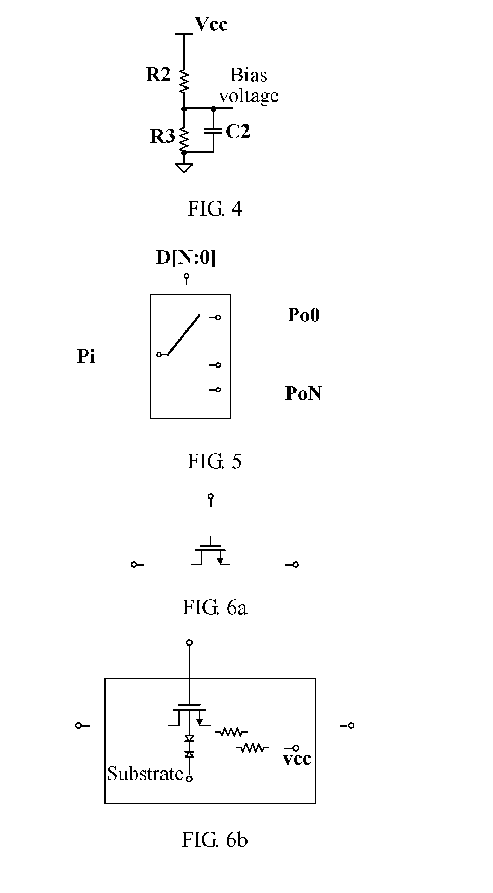

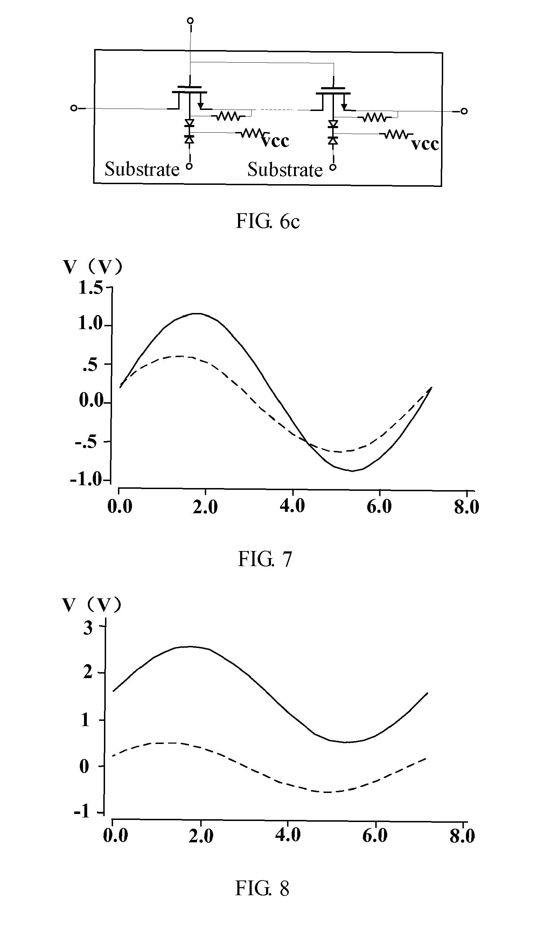

Further, the first transistor M1, the second transistor M2, and the third transistor M3 in the switch unit 12 may be triple-well transistors. Each triple-well transistor may use a process and an internal structure which exist in the industry. Or, in an internal structure, an N well is connected to a power supply by using a resistor, a P well is connected to a source of the triple-well transistor by using another resistor, and the power supply is configured to supply power to the triple-well transistor. For details, reference may be made to the following descriptions, FIG. 6b and FIG. 6c.

In the switch shown in this embodiment, a first bias voltage is set by using a first bias voltage setting circuit, which increases a direct-current level of an input signal, and avoids as far as possible that a switch which should be turned on is turned off in a case where a large signal is input into a switch circuit. Further, a second bias voltage is set by using a second bias voltage setting circuit, which avoids that a switch which should be turned off is turned on in a case where a large signal is input into the switch circuit, further optimizes performance of a switch unit in an off state in the switch in a case where a large signal is input, and effectively improves the linearity and isolation of the switch.

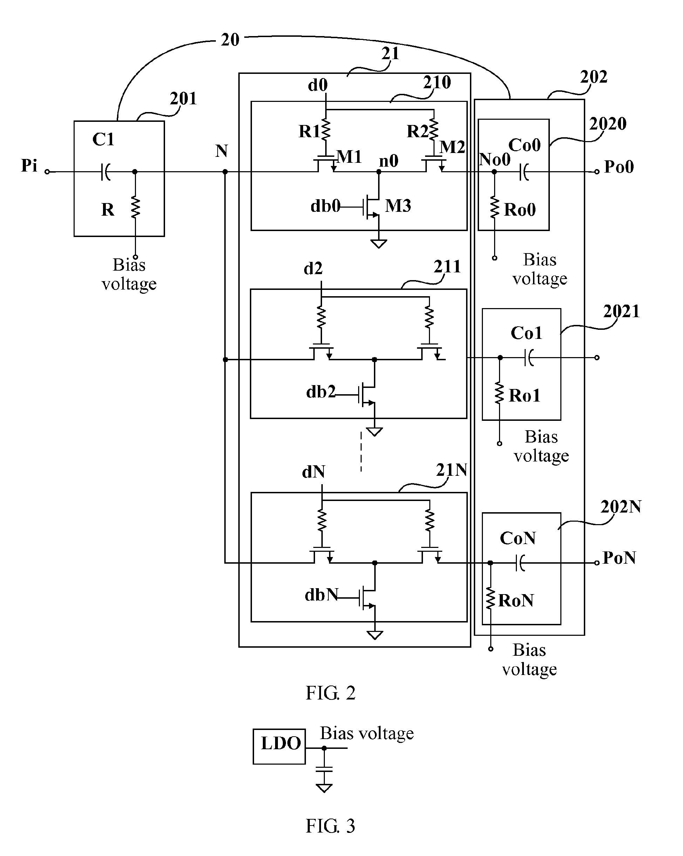

FIG. 2 is a circuit diagram of a switch according to another embodiment of the present invention. In this embodiment, the switch is a CMOS SPNT switch and includes a bias voltage setting circuit 20 and a switch circuit 21.

The bias voltage setting circuit 20 includes a main resistance-capacitance (RC) circuit 201 and N+1 branch RC circuits 2020, 2021, ..., and 202N. The main RC circuit 201 may be regarded as the first bias voltage setting circuit, and the N+1 branch RC circuits 2020, 2021, ..., and 202N may be regarded as N+1 second bias voltage setting circuits.

The main RC circuit 201 includes a blocking capacitor C1 and a resistor R, where a first end of the capacitor C1 is a signal input end (or output end) Pi, a second end thereof is connected to a first end of the resistor R and the switch circuit 21, and a second end of the resistor R is connected to a first bias voltage.

Capacitors in the N+1 branch RC circuits 2020, 2021, ..., and 202N are blocking capacitors Co0, Co1, ..., and Co N respectively, and resistors therein are Ro0, Ro1, ..., and Ro N respectively.

A structure of each branch RC circuit is similar to that of the main RC circuit 201, and differences are that a first end of the capacitor Cox (x=0, 1, ..., and N) is connected to a first end of the resistor Rox (x=0, 1, ..., and N) and the switch circuit 21, a second end of the capacitor Cox is a signal output end (or input end) Pox (x=0, 1, ..., and N), and a second end of the resistor Rox (x=0, 1, ..., and N) is connected to a second bias voltage. Since the first bias voltage is equal to the second bias voltage, both may be considered as one voltage; therefore, the both are represented as a bias voltage in FIG. 2.

In the CMOS SPNT switch provided in this embodiment, by setting a bias voltage, the linearity of the CMOS SPNT switch is greatly improved.

According to analysis and emulation verification, the bias voltage has an optimal value range, and for a CMOS process using 1.8 V or 3 V, the optimal value is 1.5 V to 1.9 V.

The bias voltage may be provided by using an integrated low-dropout linear voltage regulator (Low Dropout Regulator, LDO) circuit in a chip. As shown in FIG. 3, the bias voltage circuit may specifically include a capacitor and an LDO, where a first end of the capacitor is connected to the LDO, a resistor R, and a resistor Rox (x=0, 1, ..., and N), and a second end thereof is grounded.

Alternatively, the bias voltage may be generated by using a power supply inside or outside the chip, or a simple resistor bleeder circuit. As shown in FIG. 4, the bias voltage circuit may specifically include resistors R1 and R2 and a capacitor C2, where a first end of the resistor R1 is connected to a power supply Vcc, a second end thereof is connected to a first end of the resistor R2, a first end of the capacitor C2, a resistor R, and a resistor Rox (x=0, 1, ..., and N), and a second end of the resistor R2 and a second end of the capacitor C2 are grounded.

The switch circuit 21 includes N+1 switch units 210, 211, ..., and 21N.

The N+1 switch units 210, 211, ..., and 21N are completely the same, and the switch units are connected to the branch RC circuits in a one-to-one correspondence manner. Specifically, a switch unit 21x (x=0, 1, ..., and N) is connected to a branch RC circuit 202x (x=0, 1, ..., and N).

For the convenience of introduction, description is made in detail by using the first switch unit 210 in FIG. 2 as an example.

The switch unit 210 includes three (or three groups of) N type MOS transistors M1, M2 and M3, and resistors R1 and R2. The transistors M1 and M2 are connected in series on a signal path, a drain of the transistor M3 is connected to a connecting point n0 of M1 and M2, a source thereof is grounded, and the transistors M1, M2 and M3 are connected to form a T-shaped structure.

When the switch unit 210 is turned on, the transistors M1 and M2 are connected in series and are both turned on to play a part in transmitting a signal, and the serially connected M1 and M2 share the voltage drop on the path, which helps improve the linearity. In this case, the transistor M3 is turned off and has no effect on the path, and the node n0 presents a high-impedance state relative to the ground.

When the switch unit 210 is turned off, the transistors M1 and M2 are turned off and the transistor M3 is turned on. The transistor M1 blocks a signal passing through the path, and after the signal passes through the node n0, the signal is directly connected to the ground by the transistor M3. The turn-off of the transistor M2 further blocks the signal to pass through the path, thereby improving the isolation of the switch. The resistors R1 and R2 are configured to block the coupling of parasitic capacitances, so as to further improve the isolation and linearity.

In the switch units, signals dx (x=0, 1, ..., and N) and dbx (x=0, 1, ..., and N) which are input by control ends of the transistors, or levels dx (x=0, 1 ..., and N) and dbx (x=0, 1 ..., and N) which are connected by the transistors control turn-on and turn-off of the switch units.

A logically opposite relationship exists between dx and dbx. When a switch unit 21x (x=0, 1, ..., and N) is turned on, dx (x=0, 1, ... , and N) is set to a high level and dbx is set to a low level; and when the switch unit 21x (x=0, 1, ..., and N) is turned off, dx is set to a low level and dbx is set to a high level. FIG. 5 shows a principle diagram of a function implemented by the N+1 switch units, where D[N:0] is used to select a switch which is turned on. A D[N:0] signal includes a group of logic control signals: d0, d1,... and dN, and db0, db1,..., and dbN. Pi is a single end input (or output end), Po0 to PoN are multi-path output (or input end), and the control end D[N:0] determines that a switch among the switches is turned on and the rest switches are turned off.

To further improve the linearity of the CMOS SPNT switch when the CMOS SPNT switch is turned on, a logic high level on dx is higher than a normal logic level, for example, for CMOS processes using 1.8 V and 3 V, the logic high levels may be increased to 3 V and 5 V respectively. Since a relative voltage between a gate and a source or a drain of an MOS transistor is not increased, the reliability of the MOS transistor is ensured.

In the foregoing embodiment, a transistor shown in FIG. 6a may be a triple-well transistor generally supported by a CMOS process. The triple-well transistor uses a triple-well process, where in a separate P type well, a P well of each transistor is connected to the source of the MOS transistor by using a resistor, thereby improving the isolation between ports.

As shown in FIG. 6b, the source of the transistor is connected, by using a resistor, to a P type well where the transistor is located, which can isolate the parasitic capacitances, thereby reducing the loss.

Alternatively, as shown in FIG. 6c, multiple transistors are connected in series. Specifically, FIG. 6b shows a structure of each transistor. Gates of all serially connected transistors are connected at one point, and between any two adjacent transistors, a source of a previous transistor is connected to a drain of a next transistor. The serial connection of multiple transistors is another implementation manner of the transistor shown in FIG. 6a, and is applicable to some scenarios which have a high requirement on the linearity and do not have a high requirement on the loss of a switch.

A principle for achieving high linearity by using a bias voltage setting circuit is described in the following with reference to an emulation result.

FIG. 7 is a diagram of a relationship between an input voltage signal and a voltage on a gate of a transistor with a turned-off CMOS SPNT switch in a case where a bias voltage setting circuit is not used. A solid line indicates the input voltage signal applied on the drain of the MOS transistor, and a dashed line indicates a voltage signal on a gate of an MOS transistor. As can be seen from FIG. 7, in a case where the bias voltage is not set (that is, the bias voltage is a low level 0), a voltage of a drain negative voltage signal of the MOS transistor is already lower than a gate voltage when the input voltage signal is large; and a larger input voltage signal means a much lower voltage of the drain voltage signal of the MOS transistor at some time points in compared with the gate voltage, that is, a voltage difference between the gate voltage and the drain voltage becomes larger, which causes a switch circuit which is originally turned off to turn into a half-on and half off state or an on state at a control end in a case where a gate signal is unchanged, limiting continuous increase of the input voltage signal, further causing the linearity of the CMOS SPNT switch to be limited, and also causing the isolation to be poor in a case where a large signal is input.

FIG. 8 is a diagram of a relationship which is between an input voltage signal and a voltage on a gate of a transistor with a switch turned off and is obtained in circuit emulation of the switch shown in FIG. 2. That is, FIG. 8 provides the relationship between the input voltage signal and the voltage on the gate of the transistor with the turned-off CMOS SPNT switch in a case where the bias voltage setting circuit is used. A solid line indicates the input voltage signal applied on the drain of the MOS transistor, and a dashed line indicates a voltage on a gate of an NMOS transistor. A bias voltage of 1.8 V is set by using the bias voltage setting circuit, a logic high level is increased, and a logic low level is a zero level. As can be seen from FIG. 8, even though the input voltage signal is very large, due to the existence of the bias voltage, the voltage of the drain voltage signal is not much lower than the gate voltage, which ensures that a voltage difference between the gate voltage and the drain voltage of the MOS transistor is within a turn-off threshold, so that a turned-off MOS transistor is always in an off state; in addition, since the gate voltage is lower than the drain voltage and the source voltage, a more thorough turn-off state is achieved, thereby improving the linearity of the CMOS SPNT switch. In addition, the input voltage signal is attenuated to a greater extent when the input voltage signal passes through the MOS transistor, and therefore the signal reaching the node n0 in FIG. 2 is smaller; and then, the signal of the node n0 passes through the turned-on MOS transistor M3 and is connected to the ground, and the signal is further attenuated, thereby increasing the isolation.

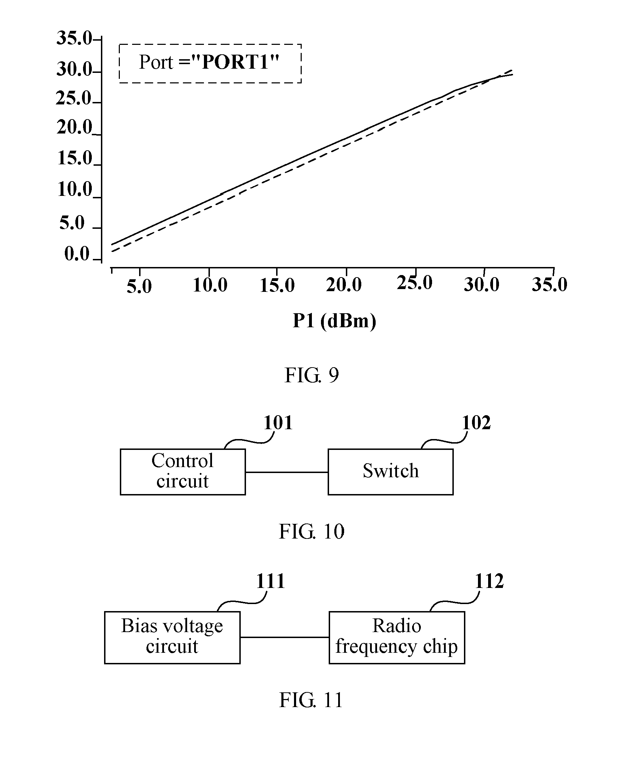

FIG. 9 is a curve diagram of an input compression point 1dB (Input Compression Point 1dB, ICP1DB) in circuit emulation of the switch shown in FIG. 2. In FIG. 9, a horizontal coordinate indicates an input power, and a vertical coordinate indicates an output power. It can be seen that ICP1dB is approximately 30 dBm, but input compression point 1dB (ICP1dB) of an existing CMOS SPNT switch is limited to approximately 15 dBm. In other words, ICP1dB of the CMOS SPNT switch put forward in the foregoing embodiment of the present invention is much higher than ICP1dB of the existing CMOS SPNT switch, that is, the linearity of the CMOS SPNT switch shown in the foregoing embodiment of the present invention is much higher than that of the existing CMOS SPNT switch.

FIG. 10 is a schematic structural diagram of a radio frequency chip according to another embodiment of the present invention. In this embodiment, the radio frequency chip includes a control circuit 101 and a switch 102. The switch 102 may be any one of the switches provided in the foregoing embodiments. The control circuit 101 is configured to provide a first control signal and a second control signal for the switch 102, where a logic level of the first control signal is opposite to a logic level of the second control signal; and the control circuit 101 controls turn-on or turn-off of at least one switch unit in the switch 102 by using the first control signal and the second control signal. For details, reference may be made to descriptions in the embodiment shown in FIG. 1.

Further, when there are multiple switch units in the switch 102, the control circuit 101 is further configured to control turn-on of any switch unit of the multiple switch units, and control turn-off of the rest switch units.

Further, the radio frequency chip provided in the embodiment of the present invention may further include a bias voltage circuit.

The bias voltage circuit is connected to a second end of a first resistor in a first bias voltage setting circuit of the switch 102, and is configured to provide a first bias voltage for the switch 102. For details of the bias voltage circuit, reference may be made to descriptions of the bias voltage circuit in the switch embodiment shown in FIG. 3. For details of the first bias voltage, reference may be made to descriptions in the switch embodiment.

When the switch 102 includes a second bias voltage setting circuit, the bias voltage circuit may further be connected to a second end of a fourth resistor in the second bias voltage setting circuit of the switch 102, and is configured to provide a second bias voltage for the switch 102, where the second bias voltage is equal to the first bias voltage. For details, reference may be made to descriptions in the switch embodiment.

When the switch 102 includes the second bias voltage setting circuit, the bias voltage circuit may include a first bias voltage circuit and a second bias voltage circuit, where:
the first bias voltage circuit is connected to the second end of the first resistor in the first bias voltage setting circuit, and is configured to provide the first bias voltage for the switch 102; and
the second bias voltage circuit is connected to the second end of the fourth resistor in the second bias voltage setting circuit, and is configured to provide the second bias voltage for the switch 102.

Both the first bias voltage and the second bias voltage may be greater than 1.5 V and less than 1.9 V.

In this embodiment, the radio frequency chip improves the reliability of signal transmission by using the switch with high linearity.

FIG. 11 is a schematic structural diagram of a board according to another embodiment of the present invention. In this embodiment, the board includes a bias voltage circuit 111 and a radio frequency chip 112. The radio frequency chip 112 may be any one of the radio frequency chips provided in the chip embodiment. The bias voltage circuit 111 is configured to provide a first bias voltage for a switch in the radio frequency chip 112.

Further, when the switch includes a second bias voltage setting circuit, the bias voltage circuit 111 is further configured to provide a second bias voltage for the switch, where the first bias voltage is equal to the second bias voltage. For details of the bias voltage circuit, the first bias voltage, and the second bias voltage, reference may be made to descriptions in the switch embodiment.

In this embodiment, the board may be a radio frequency or microwave board, and improves the reliability of signal transmission by using the radio frequency chip including the switch with high linearity.

A terminal device provided in another embodiment of the present invention includes any one of the CMOS SPNT switches provided in the foregoing embodiments. The terminal device improves the reliability of signal transmission by using the CMOS SPNT switch with high linearity.

A base station provided in another embodiment of the present invention includes any one of the CMOS SPNT switches provided in the foregoing embodiments. The base station improves the reliability of signal transmission by using the CMOS SPNT switch with high linearity.

In the radio frequency or microwave board, the terminal device, and the base station, the CMOS SPNT switch may be arranged in the radio frequency chip.

With respect to disadvantages of a commercial device on a radio frequency or microwave board, such as a high cost and an large area, the technical solutions provided in the foregoing embodiments effectively improve the linearity and isolation of a CMOS SPNT switch by using components such as a bias voltage setting circuit and a switch circuit, so that an SPNT switch circuit can be fully compatible with an existing mainstream CMOS process, which makes it possible that a high-performance CMOS SPNT switch is integrated in a chip, so as to replace an SPNT switch which is implemented by a separate commercial device on an apparatus such as a radio frequency board or a microwave board, thereby reducing the cost and area of the apparatus such as the radio frequency board or the microwave board, and complying with and promoting tendencies of the integration, miniaturization, and low cost of the apparatus such as the radio frequency board or the microwave board.

Finally, it should be noted that the foregoing embodiments are merely intended for describing the technical solutions of the present invention other than limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of the present invention.

## Claims

1. A switch, comprising:
a first bias voltage setting circuit, comprising a first capacitor and a first resistor, wherein a first end of the first capacitor is a signal input end, a second end of the first capacitor is connected to a first end of the first resistor, and a second end of the first resistor is connected to a first bias voltage; and
at least one switch unit, wherein each switch unit of the at least one switch unit comprises a first transistor, a second transistor, a third transistor, a second resistor, and a third resistor; a drain of the first transistor is connected to the second end of the first capacitor, a source of the first transistor is connected to a drain of the second transistor, and a gate of the first transistor is connected to a first end of the second resistor; a gate of the second transistor is connected to a first end of the third resistor, and a source of the second transistor is connected to a signal output end; a second end of the second resistor is connected to a second end of the third resistor and is connected to a first control signal; and a source of the third transistor is grounded, a drain of the third transistor is connected to a node on a connection line between the source of the first transistor and the drain of the second transistor, and a gate of the third transistor is connected to a second control signal, wherein the first control signal and the second control signal are used to control turn-on or turn-off of the first transistor, the second transistor, and the third transistor, and a logic level of the first control signal is opposite to a logic level of the second control signal.

2. The switch according to claim 1, further comprising:
at least one second bias voltage setting circuit, wherein the number of the at least one second bias voltage setting circuit is the same as the number of the at least one switch unit, and the at least one second bias voltage setting circuit is connected to the at least one switch unit in a one-to-one correspondence manner;
each second bias voltage setting circuit of the at least one second bias voltage setting circuit comprises a second capacitor and a fourth resistor, wherein a first end of the second capacitor, the source of the second transistor, and a first end of the fourth resistor are connected at one point, a second end of the fourth resistor is connected to a second bias voltage, and a second end of the second capacitor is a signal output end; and
the second bias voltage is equal to the first bias voltage.

3. The switch according to claim 1 or 2, wherein the first transistor, the second transistor, and the third transistor are triple-well transistors.

4. The switch according to claim 3, wherein in each triple-well transistor, an N well is connected to a power supply by using a resistor, a P well is connected to a source of the triple-well transistor by using another resistor, and the power supply is configured to supply power for the triple-well transistor.

5. The switch according to any one of claims 1 to 4, wherein high levels of the first control signal and the second control signal are greater than or equal to 2.5 V.

6. A radio frequency chip, comprising a control circuit and a switch, wherein the control circuit is configured to provide a first control signal and a second control signal for the switch, and the control circuit controls turn-on or turn-off of at least one switch unit in the switch by using the first control signal and the second control signal;
wherein the switch comprising:
a first bias voltage setting circuit, comprising a first capacitor and a first resistor, wherein a first end of the first capacitor is a signal input end, a second end of the first capacitor is connected to a first end of the first resistor, and a second end of the first resistor is connected to a first bias voltage; and
at least one switch unit, wherein each switch unit of the at least one switch unit comprises a first transistor, a second transistor, a third transistor, a second resistor, and a third resistor; a drain of the first transistor is connected to the second end of the first capacitor, a source of the first transistor is connected to a drain of the second transistor, and a gate of the first transistor is connected to a first end of the second resistor; a gate of the second transistor is connected to a first end of the third resistor, and a source of the second transistor is connected to a signal output end; a second end of the second resistor is connected to a second end of the third resistor and is connected to a first control signal; and a source of the third transistor is grounded, a drain of the third transistor is connected to a node on a connection line between the source of the first transistor and the drain of the second transistor, and a gate of the third transistor is connected to a second control signal, wherein the first control signal and the second control signal are used to control turn-on or turn-off of the first transistor, the second transistor, and the third transistor, and a logic level of the first control signal is opposite to a logic level of the second control signal.

7. The chip according to claim 6, wherein the switch further comprising:
at least one second bias voltage setting circuit, wherein the number of the at least one second bias voltage setting circuit is the same as the number of the at least one switch unit, and the at least one second bias voltage setting circuit is connected to the at least one switch unit in a one-to-one correspondence manner;
each second bias voltage setting circuit of the at least one second bias voltage setting circuit comprises a second capacitor and a fourth resistor, wherein a first end of the second capacitor, the source of the second transistor, and a first end of the fourth resistor are connected at one point, a second end of the fourth resistor is connected to a second bias voltage, and a second end of the second capacitor is a signal output end; and
the second bias voltage is equal to the first bias voltage.

8. The chip according to claim 6, wherein high levels of the first control signal and the second control signal are greater than or equal to 2.5 V.

9. The chip according to claim 6, wherein when the at least one switch unit in the switch is more than one switch unit, the control circuit is further configured to control turn-on of any switch unit of the multiple switch units and control turn-off of other switch unit than the any switch unit of the multiple switch units.

10. The chip according to any one of claims 6 to 9, wherein the chip further comprises a bias voltage circuit, wherein
the bias voltage circuit is connected to a second end of a first resistor in a first bias voltage setting circuit of the switch, and is configured to provide the first bias voltage for the switch.

11. The chip according to claim 10, wherein when the switch comprises a second bias voltage setting circuit, the bias voltage circuit is further connected to a second end of a fourth resistor in the second bias voltage setting circuit of the switch, and is configured to provide the second bias voltage for the switch, wherein the second bias voltage is equal to the first bias voltage.

12. The chip according to claim 10, wherein when the switch comprises a second bias voltage setting circuit, the bias voltage circuit comprises a first bias voltage circuit and a second bias voltage circuit;
the first bias voltage circuit is connected to the second end of the first resistor in the first bias voltage setting circuit, and is configured to provide the first bias voltage for the switch; and
the second bias voltage circuit is connected to a second end of a fourth resistor in the second bias voltage setting circuit, and is configured to provide the second bias voltage for the switch.

13. The chip according to claim 11 or 12, wherein both the first bias voltage and the second bias voltage are greater than 1.5 V and less than 1.9 V.

14. A board, comprising a bias voltage circuit and the radio frequency chip according to any one of claims 6 to 9, wherein the bias voltage circuit is configured to provide the first bias voltage for a switch in the radio frequency chip.

15. The board according to claim 14, wherein when the switch comprises a second bias voltage setting circuit, the bias voltage circuit is further configured to provide the second bias voltage for the switch, wherein the first bias voltage is equal to the second bias voltage.
